# FASCICULE DE BREVET EUROPEEN

(11) **EP 3 709 504 B1**
(45) Date de publication et mention de la délivrance du brevet: **01.06.2022**
(21) Numéro de dépôt: 20159271.4
(22) Date de dépôt: 25.02.2020
(51) Int. Cl.: H02P 29/00

(54) **PROCÉDÉ, PROGRAMME ET DISPOSITIF DE CONFIGURATION D'UN VARIATEUR DE VITESSE EN CHARGE DE L'ALIMENTATION D'UN MOTEUR ÉLECTRIQUE**
VERFAHREN, PROGRAMM UND VORRICHTUNG FÜR DIE KONFIGURATION EINES DREHZAHLREGLERS SPEISEND EINES ELEKTROMOTORS
METHOD, PROGRAMME AND DEVICE FOR CONFIGURING A SPEED VARIATOR FEEDING AN ELCTRIC MOTOR

(30) Priorité: 14.03.2019 FR 1902610
(43) Date de publication de la demande: 16.09.2020
(73) Titulaire: Schneider Toshiba Inverter Europe SAS, 27120 Pacy sur Eure (FR)
(72) Inventeur: MALRAIT, François, 27120 Jouy sur Eure (FR); DEVOS, Thomas, 78955 Carrières sous Poissy (FR); JEBAI, Al Kassem, 27120 Vernon (FR)
(74) Mandataire: Mouney, Jérôme

(56) Documents cités:
- EP-A2- 1 257 049
- EP-B1- 1 257 049
- US-A1- 2008 074 070
- US-A1- 2014 265 990

## Description

### Domaine technique de l'invention

L'invention concerne la configuration d'un variateur de vitesse en charge de l'alimentation d'un moteur électrique, et en particulier de la configuration du variateur de vitesse en fonction d'un type du moteur électrique, notamment pour les moteurs électriques triphasés.

### Etat de la technique

Les moteurs électriques peuvent être divisés en plusieurs catégories. Ils comprennent d'une part les moteurs à courant continu, et d'autre part les moteurs à courants alternatifs.

Dans un usage industriel, la plupart des moteurs à courants alternatifs sont des moteurs triphasés. Ces moteurs peuvent être alimentés directement connectés au réseau électrique, ou par un convertisseur de puissance actif, démarreur électronique ou variateur de vitesse.

Chaque type de moteur à courants alternatifs triphasés fonctionnant différemment, il est nécessaire de configurer le variateur de vitesse par des paramètres propres au type de moteur auquel il est relié.

Certains variateurs de vitesse requièrent la sélection manuelle d'un type de moteur par un utilisateur. Une telle sélection active des fonctions dédiées au type de moteur, telles que des fonctions d'alignement, de fluxage, d'identification ou de compatibilité avec d'autres fonctions.

La sélection manuelle peut comprendre la sélection d'un paramètre tel que :
- une loi de commande vectorielle, ou « *vector control* » en anglais, pour les moteurs asynchrones, qui est une commande avec boucle de vitesse ;
- une loi de commande pour les moteurs synchrones à aimants permanents qui peut également être avec boucle de vitesse sur un principe de contrôle vectoriel ;
- une loi de commande pour les moteurs synchrones à reluctance variable qui peut également être avec boucle de vitesse sur un principe de contrôle vectoriel ;
- d'autres lois de commande.

Une telle sélection manuelle est par ailleurs susceptible de présenter des erreurs, auquel cas une mauvaise configuration peut provoquer un dysfonctionnement du moteur (impossibilité de démarrer, performances dégradées, ...) jusqu'à l'endommagement du moteur électrique.

Il existe ainsi un besoin de faciliter la configuration d'un variateur de vitesse agencé pour alimenter plusieurs types de moteur électrique, tout en empêchant les erreurs liées à cette configuration.

La présente invention résout les inconvénients mentionnés ci-dessus.

Les documents US2014265990A1 et EP1257049A2 divulguent un procédé de configuration et d'identification d'un type de moteur électrique connecté à un variateur de vitesse.

### Exposé de l'invention

Un premier aspect de l'invention concerne un procédé de configuration d'un variateur de vitesse en charge de l'alimentation (triphasée par exemple) d'un moteur électrique, le procédé comprenant les opérations suivantes :
- appliquer une séquence S1 de tensions moteur au moteur électrique par le variateur de vitesse ;
- obtenir des mesures M1 de courants moteur durant l'application de la séquence S1 de tensions moteur ;
- déterminer une caractéristique C1 du moteur électrique sur la base des mesures M1 de courants moteur ;
- déterminer un type de moteur électrique au moins en fonction de la caractéristique C1 ;
- configurer le variateur de vitesse en fonction du type de moteur électrique déterminé.

Ainsi, l'invention permet de configurer, sans intervention d'un utilisateur, un variateur de vitesse en fonction du type de moteur déterminé.

Selon un mode de réalisation, la caractéristique C1 peut caractériser le fait que le moteur électrique présente ou non une propriété anisotrope.

Ainsi, des configurations différenciées selon que le moteur électrique soit anisotrope ou non peuvent être appliquées.

Laséquence S1 de tensions moteur est appliquée successivement deux fois, selon au moins deux directions non-colinéaires de tension, selon les opérations suivantes :
- appliquer la séquence S1 de tensions moteur au moteur électrique selon une direction D1 ;
- obtenir des mesures M11 de courants moteur durant l'application de la séquence de tensions moteur dans la direction D1 ;
- en cas de détermination que les mesures M11 présentent des oscillations, déterminer que le moteur électrique présente une propriété anisotrope ;
- dans le cas contraire :
   -- appliquer la séquence S1 de tensions moteur au moteur électrique une deuxième fois au moins selon une direction D2 non-colinéaire à la direction D1 ;
   -- obtenir des mesures M12 de courants moteur durant l'application de la séquence S1 de tensions moteur dans la direction D2 ;
   -- en cas de détection que les mesures M12 présentent des oscillations, déterminer que le moteur électrique présente une propriété anisotrope ;
   -- dans le cas contraire, déterminer que le moteur électrique ne présente pas de propriété anisotrope.

Un tel mode de réalisation permet d'améliorer la précision de la détection de la propriété anisotrope. En effet, des injections selon deux directions différentes et non colinéaires (de préférence espacées de 60 degrés) permettent d'assurer que l'anisotropie est détectée ou non à coup sûr. Il est en outre préférable que les deux directions D1 et D2 ne soient pas orthogonales, ce qui permet d'éviter de bloquer le moteur dans un équilibre instable dans la direction D2, notamment lorsque le moteur électrique est de type synchrone à reluctance variable.

De manière préférentielle, lorsque la séquence S1 est appliquée une deuxième fois, les applications de la séquence S1 selon différentes directions sont espacées d'un délai prédéfini, par exemple compris entre 1 et 30 secondes en fonction de la puissance du variateur de vitesse. Dans le cas d'un moteur à induction, un tel délai permet de laisser le flux magnétique revenir à zéro dans le moteur électrique entre les deux injections, permettant d'éviter une mauvaise détection du type de moteur.

En complément ou en variante, si le moteur ne présente pas de propriété anisotrope, le moteur électrique peut être déterminé comme étant de type à induction.

Il est ainsi possible de détecter un moteur électrique à induction et de configurer le variateur de vitesse qui lui est relié en conséquence.

Selon un mode de réalisation, si le moteur présente une propriété anisotrope, le procédé peut comprendre en outre :
- détecter un axe principal d'anisotropie du moteur électrique suite à l'application de la séquence S1 de tensions moteur ;
- appliquer une séquence S2 de tensions moteur pour entrainer le moteur en rotation en fonction de l'axe d'anisotropie ;
- obtenir des mesures M2 résultant de l'application de la séquence S2 de tensions moteur ;
- déterminer un type d'anisotropie du moteur électrique en fonction des mesures M2. Le type de moteur électrique est déterminé au moins en fonction de la caractéristique C1 et de la caractéristique C2.

En complément, la caractéristique C2 peut caractériser le fait que le moteur électrique comprenne un rotor ayant ou non un flux magnétique permanent.

Ainsi, des configurations différenciées selon que le moteur électrique présente un flux magnétique permanent ou non peuvent être appliquées.

Les mesures M2 peuvent être :
- des mesures de courants moteur acquises pendant l'application de la séquence S2 ;
- des mesures de tensions moteur acquises après l'application de la séquence S2.

Les mesures M2 de courants moteur permettent en effet de déterminer que le rotor comprend ou non un flux magnétique permanent. A cet effet, la séquence S2 peut consister à diminuer la tension moteur à partir d'une valeur initiale donnée, à observer le pourcentage de diminution du courant moteur et à comparer ce pourcentage avec un seuil prédéterminé, comme détaillé dans ce qui suit.

En variante, la détermination de la caractéristique C2 peut être basée non pas sur des mesures M2 de courants moteur mais sur des mesures de tensions moteur durant une phase de roue libre, comme détaillé dans ce qui suit.

Ainsi, des configurations différenciées selon que le moteur électrique présente un flux magnétique permanent ou non peuvent être appliquées.

En complément, si le moteur électrique ne comprend pas d'aimant permanent, le moteur électrique peut être déterminé comme étant de type synchrone reluctant.

Il est ainsi possible de détecter un moteur électrique de type synchrone reluctant et de configurer le variateur de vitesse qui lui est relié en conséquence.

Selon un mode de réalisation, la séquence S2 de tensions moteur peut être appliquée dans une direction orthogonale à la direction d'anisotropie du moteur électrique afin d'entraîner le moteur en rotation.

Ainsi, la séquence S2 est appliquée dans la direction favorisant l'entraînement en rotation du moteur électrique, ce qui permet d'assurer que l'injection de la séquence S2 n'endommage pas le moteur électrique dont le type n'est pas encore déterminé.

Selon un mode de réalisation, le procédé peut comprendre en outre la détermination d'un gain statique du moteur sur la base des mesures M1 et de la séquence S1, et la séquence S2 de tensions moteur peut être déterminée en fonction du gain statique déterminé.

Un tel mode de réalisation permet d'injecter une séquence S2 de tensions moteur qui n'endommage pas le moteur électrique.

Selon un mode de réalisation, si le moteur est anisotrope, une séquence S3 de tensions moteur peut être appliquée successivement deux fois, selon deux directions orthogonales de tensions, selon les opérations suivantes :
- appliquer une séquence S3 de tensions moteur au moteur électrique selon une direction D3;
- obtenir des mesures M31 de courants moteur durant l'application de la séquence S3 de tensions moteur selon la direction D3 ;
- appliquer la séquence D3 de tensions moteur au moteur électrique selon une direction D4 non-colinéaire à la direction D3 ;
- obtenir des mesures M32 de courants moteur durant l'application de la séquence S3 de tensions moteur selon la direction D4 ;
- comparer les mesures M31 et M32 afin de déterminer une caractéristique C3 du moteur électrique. Le type de moteur électrique peut être déterminé au moins en fonction de la caractéristique C1 et de la caractéristique C3.

Ainsi, la précision associée à la configuration du moteur est améliorée en ce que plusieurs caractéristiques du moteur sont prises en compte. Dans le cas où la séquence S3 est appliquée dans deux directions D3 et D4 uniquement, D3 et D4 peuvent être sensiblement orthogonales. S3 peut être appliquée selon trois directions D3, D4 et D5 espacées de 120° environ l'une par rapport à l'autre.

En complément, la caractéristique C3 peut caractériser le fait que le moteur électrique présente ou non une saillance et, si le moteur électrique ne présente pas de saillance d'inductance d'un rotor, le moteur électrique peut être déterminé comme étant du type moteur à pôle lisse à aimant permanent comme par exemple un moteur synchrone avec l'aimant en surface.

Ainsi, des configurations différenciées selon que le moteur électrique présente de la saillance ou non peuvent être appliquées.

En complément, si le moteur présente de la saillance d'inductance du rotor et si le moteur comprend un rotor comprenant un flux permanent, le moteur électrique peut être déterminé comme étant du type moteur à pôle saillant à aimant permanent comme par exemple un moteur synchrone avec l'aimant à l'intérieur.

Il est ainsi possible de détecter un moteur électrique de type saillant à aimant permanent et de configurer le variateur de vitesse qui lui est relié en conséquence.

Selon un mode de réalisation, la séquence S3 peut être une succession haute fréquence de tensions moteur ou peut être un échelon de tension.

Selon un mode de réalisation, la séquence S1 de tensions moteur consiste à augmenter progressivement la tension moteur tant que les mesures M1 de courants moteur restent inférieures à une valeur maximale de courant moteur.

Un tel mode de réalisation permet d'assurer que l'injection de la séquence S1 n'endommage pas le moteur électrique dont le type n'est alors pas déterminé.

En complément, le procédé peut comprendre une étape préliminaire de saisie manuelle de la valeur maximale de courant moteur.

La valeur maximale de courant moteur est généralement accessible de manière aisée pour l'utilisateur (elle peut être incluse dans la référence du moteur électrique).

Selon un mode de réalisation, la séquence S2 de tensions moteur peut être déterminée en fonction du gain statique et de la valeur maximale de courant moteur.

Ainsi, la séquence S2 peut être adaptée au moteur électrique de manière à ne pas l'endommager, ce qui évite de devoir monitorer en temps réel les courants moteur lors de l'injection de la séquence S2.

Un deuxième aspect de l'invention concerne un programme exécutable par un processeur et comprenant des instructions pour, lorsqu'il est exécuté par le processeur, mettre en œuvre les étapes d'un procédé selon le premier aspect de l'invention.

Un troisième aspect de l'invention concerne un dispositif de configuration d'un variateur de vitesse en charge de l'alimentation (triphasée par exemple) d'un moteur électrique, suivant la revendication 18.

### Brève description des figures

A titre d'exemple seulement, les modes de réalisation de l'invention seront décrits en référence aux dessins, parmi lesquels :
[FIG.1] - la figure 1 illustre un système de pilotage de l'alimentation d'un moteur électrique selon un mode de réalisation de l'invention ;
[FIG. 2] - la figure 2 illustre la structure d'un dispositif de commande selon des modes de réalisation de l'invention ;
[FIG. 3] - la figure 3 est un diagramme illustrant les étapes d'un procédé selon un mode de réalisation général de l'invention ;
[FIG. 4] - la figure 4 est un diagramme illustrant les étapes d'un procédé selon un mode de réalisation spécifique de l'invention ;
[FIG. 5] - la figure 5 illustre la structure d'une unité d'un dispositif de configuration selon un mode de réalisation de l'invention.

### Description détaillée

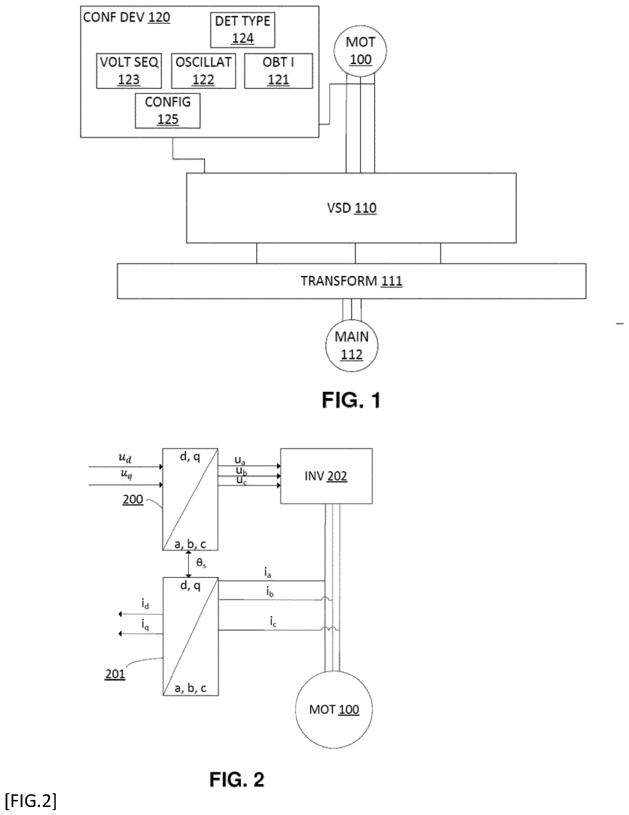

La Figure 1 présente un système selon un mode de réalisation de l'invention.

Le système comprend un variateur de vitesse 110, un moteur électrique 100 et un dispositif de configuration 120 selon un mode de réalisation de l'invention. Le dispositif de configuration peut être intégré dans le variateur de vitesse 110 ou peut être séparé du variateur de vitesse 110.

Le variateur de vitesse 110 peut être alimenté par un transformateur 111 relié à un réseau principal 112 d'électricité, tel qu'un réseau fournissant une alimentation triphasée.

Le dispositif de configuration 120 comprend :
- une unité d'obtention de courants moteur 121 ;
- une unité de détection d'oscillations 122 ;
- une unité d'injection de séquences de tensions moteur 123 ;
- une unité de détermination d'un type de moteur 124 ;
- une unité de configuration du variateur de vitesse 125.

Dans la suite de la description, le moteur électrique 100 est de type triphasé. Toutefois, aucune restriction n'est attachée à l'alimentation du moteur électrique.

Le procédé peut être mis en œuvre lors d'une étape de paramétrage ("commissioning") avant le fonctionnement normal du moteur dans le cadre de son application.

Le procédé peut être mis en oeuvre une seule fois pour identifier le type de moteur électrique.

Un variateur de vitesse 110 comporte classiquement, mais de manière non limitative :
- Un étage redresseur connecté à une source d'alimentation électrique pour recevoir une tension alternative ; L'étage redresseur pourra être de type passif tel qu'un pont de diodes ou actif à base de transistors commandés ;
- Un bus continu d'alimentation sur lequel est appliqué la tension redressée par l'étage redresseur et comprenant notamment deux lignes de bus et au moins un condensateur de bus connecté entre les deux lignes pour stabiliser la tension du bus;
- Un étage onduleur connecté en sortie du bus continu et destiné à découper la tension continue fournie par le bus en une tension variable à destination du moteur électrique 100. L'étage onduleur comporte plusieurs bras de commutation comportant chacun des transistors de puissance commandés pour appliquer la tension variable au moteur électrique.

Sur la figure 2, les notations suivantes seront employées :
θₛ : angle électrique ;
*u_{d}*: tension moteur sur un axe d ;
*u_{q}* : tension moteur sur un axe q ;
*i_{d}* : courant moteur sur l'axe d ;
*i_{q}* : courant moteur sur l'axe q ;
*uₐ, u_{b}* et *u_{c}* :tensions moteur ;
iₐ, i_{b} et i_{c} : courants moteur ;

Les axes *d* et *q* forment un repère dans un plan perpendiculaire à un axe de rotation du moteur électrique 100.

Comme illustré sur la figure 2, le variateur de vitesse 110 comprend un étage onduleur 202 qui peut être piloté directement par des tensions moteurs *uₐ, u_{b}* et *u_{c}* ou par des tensions moteur sur les axes d et q, via l'intermédiaire d'un bloc de transformation 200. Le bloc de transformation 200 est configuré pour appliquer un changement de repère, du repère d,q vers le repère *a,b,c.* Ce bloc reçoit en entrée la tension moteur *u_{d}* sur l'axe d et la tension moteur *u_{q}* sur l'axe q et détermine, à partir de l'angle θₛ, les tensions *uₐ, u_{b}* et *u_{c}* à appliquer sur les trois phases du moteur électrique 100. Un tel bloc 200 est bien connu et ne sera pas détaillé davantage dans la présente description.

Le variateur de vitesse 110 comprend en outre des moyens de mesure des courants moteur iₐ, i_{b} et i_{c}, notamment des capteurs de courant destinés à mesurer les courants iₐ, i_{b} et i_{c} présents dans les trois phases du moteur M.

Le variateur de vitesse 110 peut comprendre en outre un deuxième bloc de transformation 201 pour appliquer un changement de repère, du repère *a,b,c* vers le repère *d,q.* Ce bloc reçoit en entrée les courants iₐ, i_{b} et i_{c} mesurés sur les trois phases du moteur électrique et détermine à partir de l'angle θₛ, le courant *i_{d}* sur l'axe d et le courant *i_{q}* sur l'axe q.

L'unité d'obtention de courants moteur 121 du dispositif de configuration 120 peut être apte à recevoir les courants moteur mesurés par le variateur de vitesse 110 ou peut comprendre ses propres moyens de mesures de courants moteur iₐ, i_{b} et i_{c}, notamment des capteurs de courant destinés à mesurer les courants iₐ, i_{b} et i_{c} présents dans les trois phases du moteur M.

Le variateur de vitesse peut comprendre plusieurs lois de commande selon lesquelles il peut être configuré :
- une loi de commande vectorielle, ou « *vector control* », pour les moteurs asynchrones, qui est une commande avec boucle de vitesse ;
- une loi de commande pour les moteurs synchrones à aimants permanents qui peut également être avec boucle de vitesse sur un principe de contrôle vectoriel ;
- une loi de commande pour les moteurs synchrones à reluctance variable qui peut également être avec boucle de vitesse sur un principe de contrôle vectoriel ;
- d'autres lois de commande.

D'autres paramètres de configuration sont applicables au variateur de vitesse 110 selon l'invention, tels que des paramètres d'alignement, de fluxage, d'identification ou de compatibilité.

En particulier, l'invention prévoit de configurer de tels paramètres du variateur de vitesse 110 en fonction du type de moteur électrique auquel il est relié.

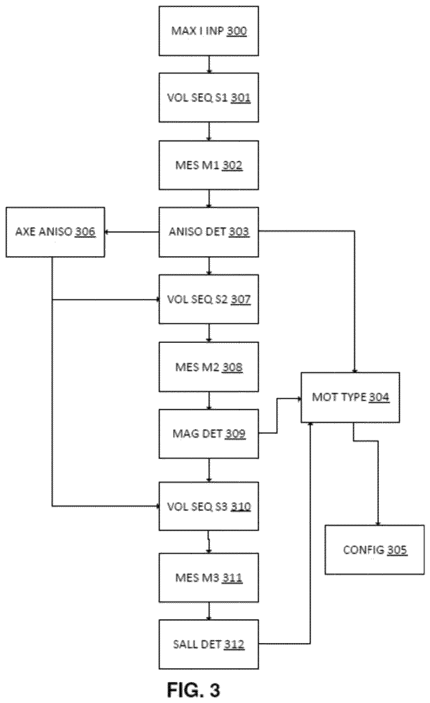

Le fonctionnement du dispositif de configuration sera mieux compris en référence à la figure 3.

La figure 3 est un diagramme illustrant les étapes d'un procédé selon un mode de réalisation de l'invention.

A une étape 300 optionnelle, une valeur maximale de courant moteur est acquise. Par exemple, une telle valeur peut être issue d'une saisie manuelle d'un utilisateur via une interface utilisateur du dispositif de configuration (non représentée sur la figure 1). Une telle étape peut être mise en œuvre préalablement aux autres étapes du procédé selon l'invention, notamment lorsque le variateur de vitesse 110 est connecté au moteur 100 ou préalablement à sa connexion au moteur électrique 100. Une telle valeur est aisément accessible par l'utilisateur, en ce qu'elle est généralement indiquée de manière explicite avec la référence du moteur électrique.

A une étape 301, une première séquence S1 de tensions moteur est transmise au variateur de vitesse 110 de manière à commander l'alimentation du moteur électrique 100, par l'unité d'injection de séquences de tensions moteur 123. Les tensions moteur de la première séquence S1 peuvent être les tensions moteur *uₐ, u_{b}* et *u_{c}* ou peuvent être les tensions moteur *u_{d}* et *u_{q}.*

Les tensions moteur peuvent notamment être transmises à un organe de commande de l'étage onduleur 202.

La première séquence S1 de tensions moteur peut comprendre une rampe de tensions croissantes à une échelle de temps lente. En particulier, les valeurs de tensions moteur peuvent être augmentées progressivement jusqu'à ce que le courant moteur atteigne la valeur maximale de courant obtenue à l'étape 300, ce qui permet de protéger le moteur électrique en garantissant que la valeur du courant moteur reste inférieure à la valeur maximale définie à l'étape 300. En effet, le type de moteur n'étant pas connu, le variateur de vitesse 110 n'est pas initialement configuré pour le type du moteur électrique 100, et il est ainsi préférable d'être prudent afin de ne pas endommager le moteur électrique 100.

A l'étape 302 qui est effectuée en parallèle de l'étape 301, des mesures M1 de courants moteur sont obtenues durant l'application de la séquence S1 de tensions moteur. Comme précédemment expliqué, les mesures M1 peuvent être obtenues d'un moyen de mesure de l'unité d'obtention de courants moteur 121, ou peut alternativement être reçu par l'unité d'obtention de courants moteur 121 depuis des moyens de mesure du variateur de vitesse 110.

A une étape 303, une caractéristique C1 du moteur électrique est déterminée en fonction des mesures M1, par l'unité de détermination du type de moteur 124. Par exemple, la caractéristique C1 peut caractériser le fait que le moteur électrique 100 présente une propriété anisotrope ou non. En pratique, il s'agit d'une anisotropie dans le rotor du moteur électrique 100. Par exemple, un moteur asynchrone comprend un rotor sous forme de cage d'écureuil qui est isotrope en fonction des directions d'injection des tensions moteurs, alors que les moteurs synchrones présentent une anisotropie et sont ainsi sensibles à la direction d'injection des tensions moteur.

S'il est déterminé que le moteur électrique 100 présente une anisotropie, l'étape 303 peut en outre comprendre la détection d'un axe principal d'anisotropie. On entend par « principal » l'axe selon lequel le degré d'anisotropie est le plus grand.

L'étape 303 peut en outre comprendre la détermination d'un gain statique du moteur (résistance statorique), notamment, en cas d'oscillations dans les mesures M1, lorsque la valeur de courant moteur s'est stabilisée après avoir oscillé.

La caractéristique d'anisotropie du moteur électrique 110 peut être déterminée en fonction de la détection ou non d'oscillations dans les mesures M1 par l'unité de détection d'oscillations 122. En particulier, les oscillations peuvent être identifiées avant que les mesures de courants moteur ne se stabilisent. Par exemple, on peut entendre par « oscillation » une succession d'au moins deux périodes de mesures respectivement supérieures/inférieures à une valeur de stabilisation vers laquelle le courant moteur converge.

Ainsi, si les mesures M1 présentent des oscillations, il peut être déduit que le moteur électrique présente une anisotropie.

Selon un mode de réalisation, la première séquence S1 est appliquée deux fois, dans deux directions D1 et D2 non-colinéaires. On entend pardirections non-colinéaires, deux vecteurs de valeurs de tensions moteur non-colinéaires entre eux. Les vecteurs comprennent deux composantes lorsque les tensions moteur *u_{d}* et *u_{q}* sont utilisées pour commander le variateur de vitesse 110, et comprennent trois composantes *uₐ, u_{b}* et *u_{c}* lorsque les tensions moteur sont utilisées pour commander le variateur de vitesse 110. De préférence, les directions D1 et D2 forment un angle sensiblement égal à 60 degrés.

En particulier, il est préférable que les deux directions D1 et D2 ne soient pas orthogonales.

Par exemple, en considérant une direction D1 correspondant à une composante nulle selon l'axe q (et non nulle selon l'axe d), la direction D2 comprend une composante non-nulle selon l'axe q et une composante non nulle selon l'axe d. Une telle réalisation permet d'éviter que le moteur électrique ne soit bloqué dans une position d'équilibre instable selon l'axe d, notamment lorsque le moteur électrique est de type synchrone à reluctance magnétique.

Dans le cas où la séquence S1 est injectée au moins deux fois, lors de la première injection de la séquence S1 dans une première direction, des mesures M11 de courants moteur sont obtenues. Selon un mode de réalisation, si les mesures M11 ne comprennent pas d'oscillations (la valeur de courant moteur se stabilise sans osciller), il est procédé à une deuxième injection dans une deuxième direction non-colinéaire à la première direction et à l'obtention de mesures M12 de courants moteur. Si, à nouveau, les mesures M12 ne comprennent pas d'oscillations, il peut être déduit que le moteur électrique 100 ne présente pas d'anisotropie. Dans le cas contraire, le moteur électrique 100 présente une anisotropie.

Le mode de réalisation avec deux injections dans des directions non-colinéaires permet d'améliorer la détection de la caractéristique C1 selon laquelle le moteur présente ou non une anisotropie.

En effet, si une seule injection était effectuée, une erreur de détection pourrait se produire dans le cas suivant : en considérant un moteur présentant une anisotropie selon un axe d'anisotropie, si la première injection est effectuée dans la direction de l'axe d'anisotropie, alors aucune oscillation n'est observée dans les mesures M1 bien que le moteur présente effectivement une anisotropie. Effectuer une deuxième injection selon un axe orthogonal permet de résoudre un tel problème.

A une étape 304, un type de moteur électrique peut être déterminé au moins sur la base de la caractéristique C1 déterminée à l'étape 303, par l'unité de détermination du type de moteur 124. D'autres caractéristiques peuvent être considérées pour déterminer le type de moteur électrique 100.

A une étape 305, l'unité de configuration 125 configure le variateur de vitesse 110 en fonction du type du moteur électrique 100. Comme indiqué précédemment, une telle configuration peut comprendre la définition de lois de commande ou la fixation d'autres paramètres de configuration.

Selon des modes de réalisation de l'invention, d'autres caractéristiques du moteur électrique 100 peuvent être déterminées afin de permettre l'identification d'autres types de moteur. En particulier, lorsque la caractéristique C1 caractérise le fait que le moteur électrique présente une propriété anisotrope, il peut être déterminé plus précisément à quoi est due l'anisotropie afin de déterminer avec précision le type du moteur électrique.

A cet effet, le procédé selon un mode de réalisation de l'invention peut comprendre en outre une étape optionnelle d'envoi d'une commande au variateur de vitesse 110 afin d'aligner le moteur électrique dans la direction de l'axe d'anisotropie déterminé à l'étape 303. Ainsi, l'axe d est aligné avec l'axe d'anisotropie du moteur électrique 100.

Selon un mode de réalisation, le procédé peut comprendre en outre les étapes 307 à 309 permettant de déterminer une deuxième caractéristique C2 du moteur électrique 100. La caractéristique C2 peut caractériser le fait que le moteur électrique 100 comprenne ou non un aimant permanent.

A l'étape 307, une deuxième séquence S2 de tensions moteur est transmise au variateur de vitesse 110 de manière à commander l'alimentation du moteur électrique 100, par l'unité d'injection de séquences de tensions moteur 123.

La deuxième séquence S2 peut être appliquée pour entrainer le moteur en rotation en fonction de l'axe d'anisotropie. De manière optimale, la première séquence S2 consiste à appliquer des tensions moteur dans une direction correspondant (ou sensiblement égale) à une normale à l'axe principal d'anisotropie déterminé à l'étape 303. La séquence S2 peut être prédéterminée. En variante, la séquence S2 peut être recalculée en fonction de la valeur maximale de courant moteur de l'étape 300 et en fonction du gain statique déterminé à l'étape 303, de manière à assurer que les tensions moteur appliquées dans la séquence S2 n'impliquent pas de dépasser la valeur maximale de courant moteur.

A l'étape 308 qui est effectuée en parallèle de l'étape 307, des mesures M2 de courant moteur sont obtenues durant l'application de la séquence S2 de tensions moteur par l'unité d'obtention ce courants moteur 121.

A l'étape 309, sur la base des mesures M2, l'unité de détermination de type de moteur 124 peut déterminer la caractéristique C2 selon laquelle le moteur électrique 100 comprend ou non un aimant permanent. Une fois que l'axe principal (aimant, reluctance) est identifié, des combinaisons de courant (i_{d},i_{q}) permettent de détecter la présence d'une tension provenant de la Force Contre-Electromotrice (Back Electromotive Force B-EMF en anglais) qui est générée par l'aimant en rotation. Cette tension est proportionnelle à la vitesse de rotation multipliée par le flux de l'aimant permanent ainsi sa présence permet de détecter la présence d'un aimant permanent.

Par exemple, la séquence S2 peut être appliquée dans une direction orthogonale à un axe de saillance *d* du moteur électrique 100. La séquence S2 peut en outre être déterminée de manière à entraîner le moteur électrique 100 à une fréquence constante.

Le courant moteur est alors mesuré dans la direction *d* de l'anisotropie du moteur pour obtenir les mesures M2. La séquence S2 peut alors consister à diminuer progressivement les tensions appliquées au moteur électrique d'un pourcentage prédéfini (sensiblement égal à 20% par exemple), et la variation des mesures M2 est analysée. Si le pourcentage de la variation du courant moteur dans les mesures M2 (valeur absolue de la différence entre la valeur initiale et la valeur finale du courant moteur selon l'axe d), par rapport à la valeur absolue de la valeur initiale du courant moteur selon l'axe *d* est inférieure à un certain seuil prédéfini (sensiblement égal à 40% par exemple), alors la caractéristique C2 peut être que le moteur électrique ne comprend pas d'aimant permanent. Dans le cas contraire, l'unité 124 peut déduire que la caractéristique C2 est que le moteur électrique 100 comprend un aimant permanent.

En variante, dans un mode de réalisation dans lequel le dispositif de configuration 120 ou le variateur de vitesse 110 comprend un moyen de mesure des tensions moteur, l'étape 308 peut consister à obtenir des mesures M2 non pas de courant moteur mais des tensions moteur. La plupart des variateurs de vitesse 110 comprennent de tels moyens de mesure, auquel cas le dispositif de configuration peut comprendre une unité d'obtention (non représentée sur la figure 1) des tensions moteur reliée au (apte à communiquer avec le) moyen de mesure du variateur de vitesse 110. Selon cette variante, la séquence S2 peut être appliquée puis le variateur de vitesse 110 est déconnecté du moteur (la partie puissance du variateur de vitesse 110 plus précisément) et les mesures M2 de tensions moteur sont acquises durant cette phase de « roue libre ». Si une tension moteur proportionnelle à la vitesse est détectée durant la phase de roue libre, alors l'unité 124 peut déterminer que le moteur électrique comprend un aimant permanent. Afin d'estimer la vitesse et l'amplitude de la tension moteur, l'unité 124 analyse les mesures M2. Si le ratio de l'amplitude de la tension sur la vitesse moteur ne varie pas ou très peu (le pourcentage de variation est inférieur à un seuil prédéterminé), alors le rotor du moteur électrique présente un flux permanent, traduisant l'existence d'un aimant permanent (caractéristique C2). Dans le cas contraire, le moteur électrique 100 ne comprend pas d'aimant permanent.

La caractéristique C2 et la caractéristique C1 peuvent être ainsi prises en compte lors de l'étape 304 de détermination du type du moteur électrique 100 mise en œuvre par l'unité de détermination de type de moteur électrique 124.

Selon un mode de réalisation, le procédé peut comprendre en outre les étapes 307 à 309 permettant de déterminer une troisième caractéristique C3 du moteur électrique 100. La caractéristique C3 peut caractériser le fait que le moteur électrique 100 présente ou non une saillance. On entend par « saillance », la caractéristique de saillance de l'inductance du moteur électrique : le flux électrique, créé par le courant électrique, circule dans le stator et le rotor. Selon la forme géométrique du rotor, ce flux électrique ne passe pas toujours par le même chemin selon la position du rotor due à la géométrie de ce dernier, ce qu'on appelle une saillance géométrique. Ainsi, dans un rotor avec des pôles saillants, les inductances selon les axes *d* et *q* sont différentes à cause de cette saillance. A l'opposé, dans un rotor à pole lisse, les inductances ne varient pas en fonction de la position du rotor.

A l'étape 310, une troisième séquence S3 de tensions moteur est transmise au variateur de vitesse 110 de manière à commander l'alimentation du moteur électrique 100, par l'unité d'injection de séquences de tensions moteur 123. La séquence S3 est injectée au moins deux fois selon au moins deux directions D3 et D4 orthogonales entre elles. Lors de chaque injection, des mesures respectives M31 et M32 de courants moteur sont acquises lors de l'étape 311 (chacune des mesures M31 à M32 est une série d'une ou plusieurs mesures). Aucune restriction n'est attachée à la séquence S3 de tensions moteur qui peut être un échelon de tension (dans le cas où le moteur électrique est équipé d'un frein), ou des tensions moteur à haute fréquence (notamment lorsque le moteur électrique n'est pas équipé de frein). En variante, la séquence S3 peut être injectée selon trois directions D3, D4 et D5. D3, D4 et D5 peuvent être séparés de 120 degrés l'une par rapport à l'autre.

Les directions D3, D4 et D5 correspondent aux trois phases du moteurs (a, b, c) dans le repère triphasé de base (situées à 120 degrés l'une par rapport à l'autre). Dans ce cas, le variateur injecte une tension très haute fréquence sur les trois phases directement. Les courants triphasés iₐ, i_{b} et i_{c} sont utilisés directement pour détecter la présence de saillance.

A l'étape 312, les mesures M31 et M32 sont comparées afin de déduire si le moteur électrique 100 présente ou non de la saillance. Par exemple, si les mesures M31 et M32 sont identiques (ou similaires, c'est-à-dire que leur différence est inférieure à un seuil donné), alors il peut être déduit par l'unité de détermination de type de moteur 124 que le moteur électrique ne présente pas de saillance (caractéristique C3). A contrario, si les mesures M31 et M32 sont différentes (leur différence est supérieure au seuil donné par exemple), il peut être déduit par l'unité de détermination de type de moteur 124 que le moteur électrique présente de la saillance (caractéristique C3).

Dans le mode de réalisation à trois injections dans trois directions D3, D4 et D5, des mesures M31, M32 et M33 sont obtenues, et les mesures sont comparées une à une afin de déduire la troisième caractéristique C3. A nouveau, si les mesures M31, M32 et M33 sont identiques deux à deux (ou similaires), l'unité de détermination de type de moteur 124 détermine que le moteur électrique 100 ne présente pas de saillance. Dans le cas contraire, l'unité de détermination de type de moteur 124 détermine que le moteur électrique 100 présente de la saillance.

Ainsi, à l'étape 304, l'unité de détermination de type de moteur 124 peut déterminer le type de moteur en prenant en compte la caractéristique C1 et la caractéristique C3, ou en prenant en compte les caractéristiques C1, C2 et C3.

Dans le mode de réalisation dans lequel à la fois les étapes 307 à 309 et 310 à 312 sont appliquées (détermination des caractéristiques C2 et C3), les étapes 310 à 312 peuvent alternativement être effectuées avant les étapes 307 à 309.

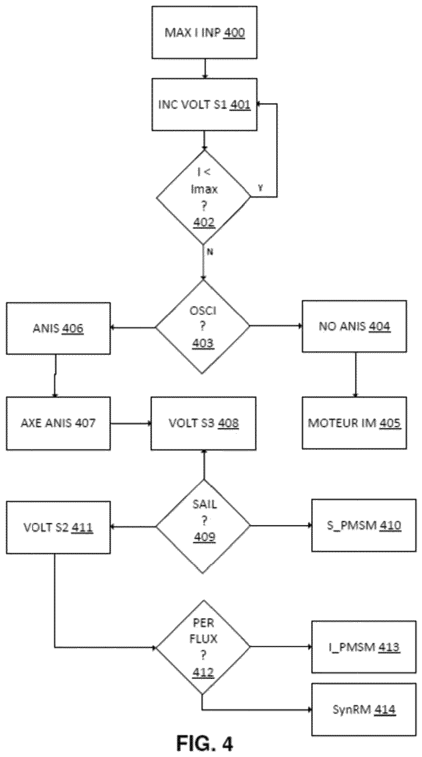

La figure 4 est un diagramme illustrant les étapes d'un procédé selon un mode de réalisation particulier de l'invention. Elle présente notamment la détermination des caractéristiques C1 à C3 afin de sélectionner un type de moteur électrique 100 parmi quatre types de moteurs électriques prédéfinis, à savoir le moteur à induction, le moteur à aimant permanent de surface (à pôle lisse), le moteur à aimant permanent intérieur (à pôle saillant) et le moteur synchrone reluctant.

L'étape 400 est similaire à l'étape 300 de la figure 3 : une valeur maximale de courant moteur est définie.

A une étape 401, une rampe S1 de tensions moteur est appliquée et le courant moteur est mesuré en même temps (mesures M1).

En parallèle, à une étape 402, le courant moteur est mesuré et comparé à la valeur maximale de courant moteur. Tant que la courant moteur mesuré est inférieur à la valeur maximale de courant moteur, la séquence S1 est poursuivie et la valeur de la tension moteur appliquée est augmentée.

Lorsque le courant mesuré atteint ou dépasse la valeur maximale de courant moteur, la séquence S1 est interrompue, le moteur 100 n'est plus alimenté par le variateur de vitesse 110 et le procédé passe à l'étape 403.

A l'étape 403, l'unité de détection d'oscillations 122 détermine si les mesures M1 présentent des oscillations ou non. Si l'unité de détection d'oscillations 122 détermine que les mesures M1 ne présentent pas d'oscillations à une étape 404, alors l'unité de détermination de type de moteur 124 détermine que le moteur est de type à induction à une étape 405.

Dans le cas contraire, l'unité de détection d'oscillations 122 détermine que les mesures M1 présentent des oscillations à une étape 406, il en est déduit que le moteur électrique présente de l'anisotropie et un axe principal d'anisotropie peut être déterminé par l'unité de détermination de type de moteur 124.

Le variateur de vitesse 110 est ensuite piloté à une étape 407 par l'unité d'injection de tensions moteur 123 de manière à aligner le moteur électrique avec l'axe principal d'anisotropie.

La séquence de tensions moteur S3 est ensuite injectée par l'unité d'injection de tensions moteur 123 à une étape 408, selon au moins deux directions D3 et D4 orthogonales entre elles. En parallèle, (au moins) les mesures M31 et M32 de courants moteur sont obtenues respectivement pour les directions D3 et D4.

L'unité de détermination de type de moteur 124 détermine, sur la base d'une comparaison des mesures M31 et M32 si le moteur électrique 100 présente de la saillance ou non à une étape 409.

Si le moteur électrique 100 ne présente pas de saillance, l'unité de détermination de type de moteur 124 détermine que le moteur électrique 100 est de type synchrone à aimant permanent en surface, à une étape 410.

Si le moteur électrique 100 présente de la saillance, l'unité d'injection de tensions moteur 123 injecte la séquence S2 de tensions moteur à une étape 411, et, en parallèle, des mesures M2 de courants moteur (ou de tensions moteur selon la variante considérée) sont obtenues.

A une étape 412, l'unité de détermination de type de moteur 124 détermine si le moteur électrique 100 présente un flux magnétique permanent ou non à une étape 412.

Si le moteur électrique 100 présente un flux magnétique permanent, l'unité de détermination de type de moteur 124 peut déterminer que le moteur électrique 100 est de type synchrone à aimant permanent intérieur, à une étape 413.

Si le moteur électrique 100 ne présente pas de flux magnétique permanent, l'unité de détermination de type de moteur 124 détermine que le moteur électrique 100 est de type synchrone reluctant, à une étape 414.

A l'issue de l'étape 405, 410, 413 ou 414, l'unité de configuration 125 configure le variateur de vitesse 110 en fonction du type de moteur électrique déterminé.

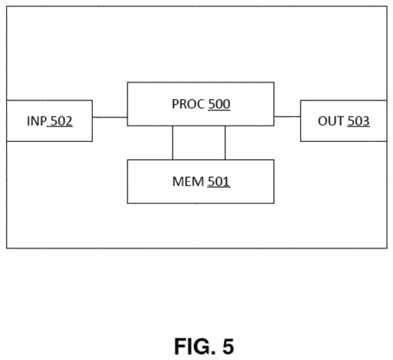

La figure 5 présente la structure de chacune des unités 122 à 125 du dispositif de configuration 120 représenté sur la figure 1.

L'unité comprend un processeur 500 associé à une mémoire 501, telle qu'une mémoire vive Random Access Memory RAM, une mémoire morte Read Only Memory, une mémoire flash, un disque dur et/ou n'importe quel type de mémoire. La mémoire 501 stocke au moins les données nécessaires à la réalisation des opérations de l'unité. Elle peut stocker en outre des instructions de programme d'ordinateur pouvant être exécutées par le processeur 500 pour la mise en œuvre des fonctionnalités de l'unité. De manière alternative, le processeur 500 peut être remplacé par un microcontrôleur conçu et configuré pour réaliser les fonctionnalités de l'unité.

L'unité comprend en outre deux interfaces d'entrée et de sortie 502 et 503. Alternativement, l'unité comprend une unique interface bidirectionnelle d'entrée/sortie. Les interfaces 502 et 503 permettent de communiquer avec les autres unités du dispositif de configuration et/ou avec le variateur de vitesse 110.

Chacune des unités 122 à 125 peut comprendre la structure représentée sur la figure 5. En variante, les fonctionnalités des unités 122 à 125 peuvent être regroupées dans une même structure avec un processeur exécutant l'ensemble de ces fonctionnalités.

Bien que la présente invention ait été décrite ci-dessus en référence à des modes de réalisation particuliers, l'invention ne se limite aucunement aux formes décrites. L'invention est uniquement limitée par ce qui est défini dans les revendications et d'autres modes de réalisation que ceux décrits ci-dessus peuvent entrer dans la portée des revendications.

En outre, bien que les modes de réalisation aient été décrits ci-dessus comme une combinaison de composants et/ou fonctions, il sera bien compris que des modes de réalisation alternatifs peuvent être obtenus par d'autres combinaisons de composants et/ou fonctions sans pour autant sortir de la portée de l'invention.

## Revendications

1. Procédé de configuration d'un variateur de vitesse (110) en charge de l'alimentation d'un moteur électrique (100), le procédé comprenant les opérations suivantes :
- appliquer (301) une séquence S1 de tensions moteur au moteur électrique via le variateur de vitesse ;
- obtenir (302) des mesures M1 de courants moteur durant l'application de la séquence S1 de tensions moteur ;
- déterminer (303) une caractéristique C1 du moteur électrique sur la base des mesures M1 de courants moteur ;
- déterminer (304) un type de moteur électrique au moins en fonction de la caractéristique C1 ;
- configurer (305) le variateur de vitesse en fonction du type de moteur électrique déterminé ;
le procédé étant **caractérisé en ce que** la séquence S1 de tension est appliquée successivement deux fois, selon au moins deux directions non colinéaires de tension, selon les opérations suivantes :
- appliquer (301) la séquence S1 de tensions moteur au moteur électrique selon une direction D1 ;
- obtenir (302) des mesures M11 de courants moteur durant l'application de la séquence de tension dans la direction D1 ;
- en cas de détermination que les mesures M11 présentent des oscillations, déterminer que le moteur électrique présente une propriété anisotrope ;
- dans le cas contraire :
-- appliquer (301) la séquence S1 de tensions moteur au moteur électrique une deuxième fois au moins selon une direction D2 non-colinéaire à la direction D1 ;
-- obtenir (302) des mesures M12 de courants moteur durant l'application de la séquence S1 de tensions moteur dans la direction D2 ;
-- en cas de détection que les mesures M12 présentent des oscillations, déterminer (303) que le moteur électrique présente une propriété anisotrope ;
-- dans le cas contraire, déterminer (303) que le moteur électrique ne présente pas de propriété anisotrope.

2. Procédé selon la revendication 1, dans lequel, lorsque la séquence S1 est appliquée une deuxième fois, les applications des séquences S1 sont au moins séparées d'un délai prédéterminé.

3. Procédé selon l'une des revendications 1 et 2, dans lequel, si le moteur électrique (100) ne présente pas de propriété anisotrope, le moteur électrique est déterminé comme étant de type à induction.

4. Procédé selon l'une des revendications 1 à 3, dans lequel si le moteur électrique (100) présente une propriété anisotrope, le procédé comprend en outre :
- détecter (306) un axe principal d'anisotropie du moteur électrique suite à l'application de la séquence S1 de tensions moteur ;
- appliquer (307) une séquence S2 de tensions moteur pour entrainer le moteur en rotation en fonction de l'axe d'anisotropie ;
- obtenir (308) des mesures M2 résultant de l'application de la séquence S2 de tensions moteur ;
- déterminer (309) un type d'anisotropie du moteur électrique en fonction des mesures M2; dans lequel le type de moteur électrique est déterminé au moins en fonction de la caractéristique C1 et de la caractéristique C2.

5. Procédé selon la revendication 4, dans lequel les mesures M2 sont :
- des mesures de courants moteur acquises pendant l'application de la séquence S2 ;
- des mesures de tensions moteur acquises après l'application de la séquence S2.

6. Procédé selon la revendication 4 ou 5, dans lequel la caractéristique C2 caractérise le fait que le moteur électrique (100) comprenne un rotor ayant ou non un flux magnétique permanent.

7. Procédé selon la revendication 6, dans lequel, si le moteur électrique (100) ne comprend pas d'aimant permanent, le moteur électrique est déterminé comme étant de type synchrone reluctant.

8. Procédé selon l'une des revendications 5 à 7, dans lequel la séquence S2 de tensions moteur est appliquée dans une direction orthogonale à la direction d'anisotropie du moteur électrique (100) afin d'entraîner le moteur électrique en rotation.

9. Procédé selon l'une des revendications 5 à 8, comprenant en outre la détermination d'un gain statique du moteur sur la base des mesures M1 et de la séquence S1, et dans lequel la séquence S2 de tensions moteur est déterminée en fonction du gain statique déterminé.

10. Procédé selon l'une des revendications 1 à 9, dans lequel, si le moteur électrique (100) est anisotrope, une séquence S3 de tensions moteur est appliquée successivement deux fois, selon deux directions orthogonales de tension, selon les opérations suivantes :
- appliquer (310) une séquence S3 de tensions moteur au moteur électrique selon une direction D3 ;
- obtenir (311) des mesures M31 de courants moteur durant l'application de la séquence S3 de tensions moteur selon la direction D3 ;
- appliquer (310) la séquence D3 de tensions moteur au moteur électrique selon une direction D4 non-colinéaire à la direction D3 ;
- obtenir (311) des mesures M32 de courants moteur durant l'application de la séquence S3 de tensions moteur selon la direction D4 ;
- comparer (312) les mesures M31 et M32 afin de déterminer une caractéristique C3 du moteur électrique ;
dans lequel le type de moteur électrique est déterminé au moins en fonction de la caractéristique C1 et de la caractéristique C3.

11. Procédé selon la revendication 10, dans lequel la caractéristique C3 caractérise le fait que le moteur électrique (100) présente ou non une saillance et dans lequel, si le moteur électrique ne présente pas de saillance d'inductance d'un rotor, le moteur électrique est déterminé comme étant du type à aimant permanent de surface.

12. Procédé selon la revendication 6 et la revendication 11, dans lequel si le moteur électrique (100) présente de la saillance d'inductance du rotor et si le moteur comprend un rotor comprenant un flux permanent, le moteur électrique est déterminé comme étant du type à aimant permanent intérieur.

13. Procédé selon l'une des revendications 10 à 12, dans lequel la séquence S3 est une succession haute fréquence de tensions ou est un échelon de tension.

14. Procédé selon l'une des revendications précédentes, dans lequel la séquence S1 de tensions moteur consiste à augmenter progressivement la tension moteur tant que les mesures M1 de courant moteur restent inférieures à une valeur maximale de courant moteur.

15. Procédé selon la revendication 14, comprenant une étape préliminaire (300) de saisie manuelle de la valeur maximale de courant moteur.

16. Procédé selon la revendication 9 et selon la revendication 14 ou 15, dans lequel la séquence S2 de tension est déterminée en fonction du gain statique et de la valeur maximale de courant moteur.

17. Programme d'ordinateur exécutable par un processeur (500) et comprenant des instructions pour, lorsqu'il est exécuté par le processeur, mettre en œuvre les étapes d'un procédé selon l'une des revendications 1 à 16.

18. Dispositif de configuration d'un variateur de vitesse (110) en charge de l'alimentation d'un moteur électrique (100), le dispositif de configuration comprenant :
- une unité d'injection de tensions (123) configurée pour appliquer une séquence S1 de tensions moteur au moteur électrique par l'intermédiaire du variateur de vitesse ;
- une unité d'obtention (121) configurée pour obtenir des mesures M1 de courant moteur durant l'application de la séquence S1 de tension ;
- une unité de détermination de type de moteur (124) configurée pour déterminer une caractéristique C1 du moteur électrique sur la base des mesures M1 de courant moteur et pour déterminer un type de moteur électrique au moins en fonction de la caractéristique C1 ;
- une unité de configuration (125) capable de configurer le variateur de vitesse en fonction du type de moteur électrique déterminé,
le dispositif étant **caractérisé en ce que** l'unité d'injection de tensions (123) est configurée pour appliquer la séquence S1 de tension successivement deux fois, selon au moins deux directions non colinéaires de tension, et **en ce que** :
- l'unité d'injection de tensions (123) est configurée pour appliquer la séquence S1 de tensions moteur au moteur électrique selon une direction D1 ;
- l'unité d'obtention (121) est configurée pour obtenir (302) des mesures M11 de courants moteur durant l'application de la séquence de tension dans la direction D1 ;
- en cas de détermination que les mesures M11 présentent des oscillations, l'unité de détermination de type de moteur (124) est configurée pour déterminer que le moteur électrique présente une propriété anisotrope,
- dans le cas contraire :
-- l'unité d'injection de tensions (123) est configurée pour appliquer la séquence S1 de tensions moteur au moteur électrique une deuxième fois au moins selon une direction D2 non-colinéaire à la direction D1 ;
-- l'unité d'obtention (121) est configurée pour obtenir des mesures M12 de courants moteur durant l'application de la séquence S1 de tensions moteur dans la direction D2 ;
-- en cas de détection que les mesures M12 présentent des oscillations, l'unité de détermination de type de moteur (124) est configurée pour déterminer que le moteur électrique présente une propriété anisotrope ;
-- dans le cas contraire, l'unité de détermination de type de moteur (124) est configurée pour déterminer que le moteur électrique ne présente pas de propriété anisotrope.

## Patentansprüche

1. Verfahren für die Konfiguration eines Drehzahlreglers (110), der einen Elektromotor (100) speist, wobei das Verfahren die folgenden Vorgänge umfasst:
- Anlegen (301) einer Motorspannungssequenz S1 an den Elektromotor über den Drehzahlregler;
- Erhalten (302) von Motorstrommesswerten M1 während des Anliegens der Motorspannungssequenz S1;
- Bestimmen (303) einer Eigenschaft C1 des Elektromotors auf Grundlage der Motorstrommesswerte M1;
- Bestimmen (304) eines Elektromotortyps mindestens in Abhängigkeit von der Eigenschaft C1;
- Konfigurieren (305) des Drehzahlreglers in Abhängigkeit vom bestimmten Elektromotortyp;
wobei das Verfahren **dadurch gekennzeichnet ist, dass** die Spannungssequenz S1 zweimal nacheinander in mindestens zwei nicht kolinearen Spannungsrichtungen gemäß den folgenden Vorgängen angelegt wird:
- Anlegen (301) der Motorspannungssequenz S1 an den Elektromotor in einer Richtung D1;
- Erhalten (302) von Motorstrommesswerten M11 während des Anliegens der Spannungssequenz in der Richtung D1;
- im Fall einer Feststellung, dass die Messwerte M11 Schwankungen aufweisen, Feststellen, dass der Elektromotor eine anisotrope Eigenschaft aufweist;
- im gegenteiligen Fall:
- Anlegen (301) der Motorspannungssequenz S1 an den Elektromotor ein zweites Mal mindestens in einer zur Richtung D1 nicht kolinearen Richtung D2;
- Erhalten (302) der Motorstrommesswerte M12 während des Anliegens der Motorspannungssequenz S1 in die Richtung D2;
- im Fall des Erkennens, dass die Messwerte M12 Schwankungen aufweisen, Feststellen (303), dass der Elektromotor eine anisotrope Eigenschaft aufweist;
- im gegenteiligen Fall Feststellen (303), dass der Elektromotor keine anisotrope Eigenschaft aufweist.

2. Verfahren nach Anspruch 1, wobei Anlegungen der Sequenzen S1 mindestens durch eine vorgegebene Verzögerung getrennt sind, wenn die Sequenz S1 ein zweites Mal angelegt wird.

3. Verfahren nach einem der Ansprüche 1 und 2, wobei der Elektromotor, wenn der Elektromotor (100) keine anisotrope Eigenschaft aufweist, als vom Induktionstyp bestimmt wird.

4. Verfahren nach einem der Ansprüche 1 bis 3, wobei das Verfahren, wenn der Elektromotor (100) eine anisotrope Eigenschaft aufweist, außerdem umfasst:
- Erkennen (306) einer Anisotropiehauptachse des Elektromotors nach Anlegen der Motorspannungssequenz S1;
- Anlegen (307) einer Motorspannungssequenz S2, um den Motor in Abhängigkeit von der Anisotropieachse in Drehung zu versetzen;
- Erhalten (308) von Messwerten M2, die sich aus dem Anlegen der Motorspannungssequenz S2 ergeben;
- Bestimmen (309) eines Anisotropietyps des Elektromotors in Abhängigkeit von den Messwerten M2;
wobei der Elektromotortyp mindestens in Abhängigkeit von der Eigenschaft C1 und der Eigenschaft C2 bestimmt wird.

5. Verfahren nach Anspruch 4, wobei die Messwerte M2 sind:
- Motorstrommesswerte, die während des Anliegens der Sequenz S2 erfasst werden;
- Motorspannungsmesswerte, die nach Anlegen der Sequenz S2 erfasst werden.

6. Verfahren nach Anspruch 4 oder 5, wobei die Eigenschaft C2 die Tatsache kennzeichnet, dass der Elektromotor (100) einen Rotor umfasst, der einen permanenten Magnetfluss aufweist oder nicht.

7. Verfahren nach Anspruch 6, wobei der Elektromotor, wenn der Elektromotor (100) keinen Permanentmagnet umfasst, als vom synchronen Reluktanztyp bestimmt wird.

8. Verfahren nach einem der Ansprüche 5 bis 7, wobei die Motorspannungssequenz S2 in einer Richtung angelegt wird, die orthogonal zur Anisotropierichtung des Elektromotors (100) verläuft, um den Elektromotor in Drehung zu versetzen.

9. Verfahren nach einem der Ansprüche 5 bis 8, das außerdem die Bestimmung einer statischen Verstärkung des Motors auf Grundlage der Messwerte M1 und der Sequenz S1 umfasst und wobei die Motorspannungssequenz S2 in Abhängigkeit von der bestimmten statischen Verstärkung bestimmt wird.

10. Verfahren nach einem der Ansprüche 1 bis 9, wobei eine Motorspannungssequenz S3, wenn der Elektromotor (100) anisotrop ist, zweimal nacheinander in zwei orthogonale Spannungsrichtungen gemäß folgenden Vorgängen angelegt wird:
- Anlegen (310) einer Motorspannungssequenz S3 an den Elektromotor in einer Richtung D3;
- Erhalten (311) von Motorstrommesswerten M31 während des Anliegens der Motorspannungssequenz S3 in der Richtung D3;
- Anlegen (310) einer Sequenz D3 von Motorspannungen an den Elektromotor in einer zur Richtung D3 nicht kolinearen Richtung D4;
- Erhalten (311) von Motorstrommesswerten M32 während des Anliegens der Motorspannungssequenz S3 in der Richtung D4;
- Vergleichen (312) der Messwerte M31 und M32, um eine Eigenschaft C3 des Elektromotors zu bestimmen;
wobei der Elektromotortyp mindestens in Abhängigkeit von der Eigenschaft C1 und der Eigenschaft C3 bestimmt wird.

11. Verfahren nach Anspruch 10, wobei die Eigenschaft C3 die Tatsache kennzeichnet, dass der Elektromotor (100) eine Salienz aufweist oder nicht, und wobei der Elektromotor, wenn der Elektromotor keine Induktionssalienz eines Rotors aufweist, als vom Typ mit oberflächlich angeordnetem Permanentmagnet bestimmt wird.

12. Verfahren nach Anspruch 6 und Anspruch 11, wobei der Elektromotor, wenn der Elektromotor (100) eine Induktionssalienz des Rotors aufweist und der Motor einen Rotor umfasst, der einen permanenten Fluss umfasst, als vom Typ mit innerem Permanentmagnet bestimmt wird.

13. Verfahren nach einem der Ansprüche 10 bis 12, wobei die Sequenz S3 eine hochfrequente Abfolge von Spannungen oder ein Spannungssprung ist.

14. Verfahren nach einem der vorhergehenden Ansprüche, wobei die Motorspannungssequenz S1 darin besteht, die Motorspannung fortschreitend zu erhöhen, solange die Motorstrommesswerte M1 kleiner als ein Maximalwert des Motorstroms bleiben.

15. Verfahren nach Anspruch 14, das einen vorbereitenden Schritt (300) der manuellen Erfassung des Maximalwertes des Motorstroms umfasst.

16. Verfahren nach Anspruch 9 und nach Anspruch 14 oder 15, wobei die Spannungssequenz S2 in Abhängigkeit von der statischen Verstärkung und dem Maximalwert des Motorstroms bestimmt wird.

17. Computerprogramm, das durch einen Prozessor (500) ausführbar ist und Anweisungen umfasst, um bei Ausführung durch den Prozessor die Schritte eines Verfahrens nach einem der Ansprüche 1 bis 16 umzusetzen.

18. Vorrichtung für die Konfiguration eines Drehzahlreglers (110), der einen Elektromotor (100) speist, wobei die Vorrichtung für die Konfiguration umfasst:
- eine Spannungseinspeiseeinheit (123), die dazu konfiguriert ist, eine Motorspannungssequenz S1 mittels eines Drehzahlreglers an den Elektromotor anzulegen;
- eine Erhaltenseinheit (121), die dazu konfiguriert ist, Motorstrommesswerte M1 während des Anliegens der Spannungssequenz S1 zu erhalten;
- eine Motortypbestimmungseinheit (124), die dazu konfiguriert ist, eine Eigenschaft C1 des Elektromotors auf Grundlage der Motorstrommesswerte M1 zu bestimmen und einen Elektromotortyp mindestens in Abhängigkeit von der Eigenschaft C1 zu bestimmen;
- eine Konfigurationseinheit (125), die dazu konfiguriert ist, den Drehzahlregler in Abhängigkeit vom bestimmten Elektromotortyp zu konfigurieren,
wobei die Vorrichtung **dadurch gekennzeichnet ist, dass** die Spannungseinspeiseeinheit (123) dazu konfiguriert ist, die Spannungssequenz S1 zweimal nacheinander in mindestens zwei nicht kolinearen Spannungsrichtungen anzulegen, und dass
- die Spannungseinspeiseeinheit (123) dazu konfiguriert ist, die Motorspannungssequenz S1 in einer Richtung D1 an den Elektromotor anzulegen;
- die Erhaltenseinheit (121) dazu konfiguriert ist, Motorstrommesswerte M11 während des Anliegens der Spannungssequenz in der Richtung D1 zu erhalten (302);
- im Falle einer Feststellung, dass die Messwerte M11 Schwankungen aufweisen, die Motortypbestimmungseinheit (124) dazu konfiguriert ist, festzustellen, dass der Elektromotor eine anisotrope Eigenschaft aufweist,
- im gegenteiligen Fall:
- die Spannungseinspeiseeinheit (123) dazu konfiguriert ist, die Motorspannungssequenz S1 ein zweites Mal mindestens in einer zur Richtung D1 nicht kolinearen Richtung D2 anzulegen;
- die Erhaltenseinheit (121) dazu konfiguriert ist, Motorstrommesswerte M12 während des Anliegens der Motorspannungssequenz S1 in der Richtung D2 zu erhalten;
- im Falle einer Feststellung, dass die Messwerte M12 Schwankungen aufweisen, die Motortypbestimmungseinheit (124) dazu konfiguriert ist, festzustellen, dass der Elektromotor eine anisotrope Eigenschaft aufweist,
- im gegenteiligen Fall die Motortypbestimmungseinheit (124) dazu konfiguriert ist, festzustellen, dass der Elektromotor keine anisotrope Eigenschaft aufweist.

## Claims

1. Method for configuring a variable speed drive (110) for supplying an electric motor (100), the method comprising the following operations:
- applying (301) a sequence S1 of motor voltages to the electric motor via the variable speed drive;
- obtaining (302) measurements M1 of motor currents during the application of the sequence S1 of motor voltages;
- determining (303) a feature C1 of the electric motor on the basis of the measurements M1 of motor currents;
- determining (304) a type of electric motor at least as a function of the feature C1;
- configuring (305) the variable speed drive as a function of the determined type of electric motor;
the method being **characterized in that** the voltage sequence S1 is applied successively twice, in at least two non-colinear voltage directions, according to the following operations:
- applying (301) the sequence S1 of motor voltages to the electric motor in a direction D1;
- obtaining (302) measurements M11 of motor currents during the application of the voltage sequence in the direction D1;
- in case of determination that the measurements M11 exhibit oscillations, determining that the electric motor exhibits an anisotropic property;
- otherwise:
-- applying (301) the sequence S1 of motor voltages to the electric motor a second time at least in a direction D2 non-colinear to the direction D1;
-- obtaining (302) measurements M12 of motor currents during the application of the sequence S1 of motor voltages in the direction D2;
-- in case of detection that the measurements M12 exhibit oscillations, determining (303) that the electric motor exhibits an anisotropic property;
-- otherwise, determining (303) that the electric motor does not exhibit any anisotropic property.

2. Method according to Claim 1, wherein, when the sequence S1 is applied a second time, the applications of the sequences S1 are at least separated by a predetermined delay.

3. Method according to one of Claims 1 and 2, wherein, if the electric motor (100) does not exhibit any anisotropic property, the electric motor is determined to be of induction type.

4. Method according to one of Claims 1 to 3, wherein, if the electric motor (100) exhibits an anisotropic property, the method further comprises:
- detecting (306) a main anisotropy axis of the electric motor following the application of the sequence S1 of motor voltages;
- applying (307) a sequence S2 of motor voltages to drive the motor in rotation as a function of the anisotropy axis;
- obtaining (308) measurements M2 resulting from the application of the sequence S2 of motor voltages;
- determining (309) a type of anisotropy of the electric motor as a function of the measurements M2;
wherein the type of electric motor is determined at least as a function of the feature C1 and of the feature C2.

5. Method according to Claim 4, wherein the measurements M2 are:
- measurements of motor currents acquired during the application of the sequence S2;
- measurements of motor voltages acquired after the application of the sequence S2.

6. Method according to Claim 4 or 5, wherein the feature C2 characterizes the fact that the electric motor (100) comprises a rotor having or not having a permanent magnetic flux.

7. Method according to Claim 6, wherein, if the electric motor (100) does not comprise any permanent magnet, the electric motor is determined to be of reluctant synchronous type.

8. Method according to one of Claims 5 to 7, wherein the sequence S2 of motor voltages is applied in a direction orthogonal to the direction of anisotropy of the electric motor (100) in order to drive the electric motor in rotation.

9. Method according to one of Claims 5 to 8, further comprising the determination of a steady-state gain of the motor on the basis of the measurements M1 and of the sequence S1, and wherein the sequence S2 of motor voltages is determined as a function of the determined steady-state gain.

10. Method according to one of Claims 1 to 9, wherein, if the electric motor (100) is anisotropic, a sequence S3 of motor voltages is applied successively twice, in two orthogonal voltage directions, according to the following operations:
- applying (310) a sequence S3 of motor voltages to the electric motor in a direction D3;
- obtaining (311) measurements M31 of motor currents during the application of the sequence S3 of motor voltages in the direction D3;
- applying (310) the sequence D3 of motor voltages to the electric motor in a direction D4 non-colinear to the direction D3;
- obtaining (311) measurements M32 of motor currents during the application of the sequence S3 of motor voltages in the direction D4;
- comparing (312) the measurements M31 and M32 in order to determine a feature C3 of the electric motor;
wherein the type of electric motor is determined at least as a function of the feature C1 and of the feature C3.

11. Method according to Claim 10, wherein the feature C3 characterizes the fact that the electric motor (100) exhibits or does not exhibit a salience and wherein, if the electric motor does not exhibit any salience of inductance of a rotor, the electric motor is determined to be of the type with surface permanent magnet.

12. Method according to Claim 6 and Claim 11, wherein, if the electric motor (100) exhibits salience of inductance of the rotor and if the motor comprises a rotor comprising a permanent flux, the electric motor is determined to be of the type with internal permanent magnet.

13. Method according to one of Claims 10 to 12, wherein the sequence S3 is a highfrequency succession of voltages or is a voltage step.

14. Method according to one of the preceding claims, wherein the sequence S1 of motor voltages consists in progressively increasing the motor voltage as long as the measurements M1 of motor current remain below a maximum motor current value.

15. Method according to Claim 14, comprising a preliminary step (300) of manual input of the maximum motor current value.

16. Method according to Claim 9 and according to Claim 14 or 15, wherein the voltage sequence S2 is determined as a function of the steady-state gain and of the maximum motor current value.

17. Computer program that can be run by a processor (500) and comprising instructions for, when it is run by the processor, implementing the steps of a method according to one of Claims 1 to 16.

18. Device for configuring a variable speed drive (110) in charge of power supply of an electric motor (100), the configuration device comprising:
- a voltage injection unit (123) set up to apply a sequence S1 of motor voltages to the electric motor via the variable speed drive;
- an obtaining unit (121) set up to obtain measurements M1 of motor current during the application of the voltage sequence S1;
- a motor type determination unit (124) set up to determine a feature C1 of the electric motor on the basis of the motor current measurements M1 and to determine an electric motor type at least as a function of the feature C1;
- a configuration unit (125) capable of configuring the variable speed drive as a function of the determined electric motor type,
the device being **characterized in that** the voltage injection unit (123) is set up to apply the voltage sequence S1 successively twice, in at least two non-colinear voltage directions, and **in that**:
- the voltage injection unit (123) is set up to apply a sequence S1 of motor voltages to the electric motor in a direction D1;
- the obtaining unit (121) is set up to obtain (302) measurements M11 of motor current during the application of the voltage sequence S1 in the direction D1;
- in case of determination that the measurements M11 exhibit oscillations, the motor type determination unit (124) is set up to determine that the electric motor exhibits an anisotropic property;
- otherwise:
-- the voltage injection unit (123) is set up to apply the sequence S1 of motor voltages to the electric motor a second time at least in a direction D2 non-colinear to the direction D1;
-- the obtaining unit (121) is set up to obtain measurements M12 of motor current during the application of the sequence S1 of motor voltages in the direction D2;
-- in case of determination that the measurements M12 exhibit oscillations, the motor type determination unit (124) is set up to determine that the electric motor exhibits an anisotropic property;
-- otherwise, the motor type determination unit (124) is set up to determine that the electric motor does not exhibit any anisotropic property.
